# EUROPÄISCHE PATENTSCHRIFT

(11) **EP 3 300 840 B1**
(45) Veröffentlichungstag und Bekanntmachung des Hinweises auf die Patenterteilung: **03.11.2021**
(21) Anmeldenummer: 17401102.3
(22) Anmeldetag: 26.09.2017
(51) Int. Cl.: B25J 9/04, H01L 21/677, H01L 21/67, B25J 9/00, B25J 11/00, H01L 21/68

(54) **HANDHABUNGSVORRICHTUNG FÜR SUBSTRATE, INSBESONDERE HALBLEITERSUBSTRATE**
HANDLING DEVICE FOR SUBSTRATES, ESPECIALLY SEMICONDUCTOR SUBSTRATES
DISPOSITIF DE MANIPULATION POUR SUBSTRATS, EN PARTICULIER POUR SUBSTRATS SEMI-CONDUCTEURS

(30) Priorität: 29.09.2016 DE 102016118462
(43) Veröffentlichungstag der Anmeldung: 04.04.2018
(73) Patentinhaber: ASYS Automatic Systems GmbH & Co. KG, 73614 Schorndorf (DE)
(72) Erfinder: HÜGLER, Klaus, 73630 Remshalden (DE)
(74) Vertreter: Müller, Gottfried

(56) Entgegenhaltungen:
- WO-A1-2015/116674
- JP-A- H11 288 996
- US-A- 5 102 280
- US-A1- 2001 041 129
- US-A1- 2009 082 895
- US-A1- 2015 179 488
- US-B1- 6 746 196

## Beschreibung

Die Erfindung betrifft eine Handhabungsvorrichtung für Substrate gemäß dem Anspruch 1.

Aus der US 2015/0179488 A1 ist eine Handhabungsvorrichtung für Substrate mit zentraler Drehachse für eine auf einen Endeffektor mit zumindest einer Substratauflage auslaufenden Robotik bekannt, bei der versetzt hierzu eine im Zugriffsbereich des Endeffektors der Robotik liegende Positioniereinrichtung mit zur zentralen Drehachse senkrecht liegendem, drehbaren Auflageteller für die umzusetzenden Substrate vorgesehen ist, wobei die Positioniereinrichtung bei eigenständiger Abstützung zur Basis der Robotik zu dieser drehend angetrieben ist.

Die Dokumente JPH11-288996-A1 und WO2015/116674-A1 zeigen weitere Handhabungsvorrichtungen aus dem Stand der Technik.

Über eine solche Handhabungsvorrichtung ist eine genaue Positionierung der Substrate auf der Substratauflage des jeweiligen Endeffektors zu erreichen, bei minimalem Zeitbedarf für die jeweilige Umsetzung der Substrate, bei möglichst geringem Platzbedarf für die Handhabungsvorrichtung, bei einfachem Aufbau der Handhabungsvorrichtung und bei hohem Durchsatz von über die Handhabungsvorrichtung umzusetzenden Substraten.

Entsprechende Vorteile sind in Verbindung mit einem geringen Entwicklungsaufwand auch mit der erfindungsgemäßen Handhabungsvorrichtung angestrebt.

Erreicht wird dies durch eine Ausgestaltung der Handhabungsvorrichtung mit zentraler Drehachse für eine auf einen Endeffektor mit zumindest einer Substratauflage auslaufenden Robotik und im Zugriffsbereich des Endeffektors der Robotik liegender Positioniereinrichtung mit zur zentralen Drehachse senkrecht liegendem, drehbaren Auflageteller für die umzusetzenden Substrate, wobei die Positioniereinrichtung einen Bestandteil der Robotik bildet und zur Robotik synchron mitdrehend angetrieben ist sowie ferner die Robotik eine Gliederkette bildet, die Positioniereinrichtung drehfest gegen den mit einer zur zentralen Drehachse koaxialen Welle verbundenen Oberarm der Robotik festgelegt ist und die Handhabungsvorrichtung gekapselt und mit atmosphärisch gegeneinander abgegrenzten Aufnahmeräumen für zumindest jeweils Teile der Robotik und Teile der Positioniereinrichtung vakuumtauglich ausgebildet ist.

Die erfindungsgemäße Handhabungsvorrichtung kann sowohl allgemein wie auch Reinraumbedingungen entsprechend eingesetzt werden, da die Integration der Positioniereinrichtung in die Robotik auch atmosphärisch gekapselt erfolgen kann und über die bauliche Zusammenfassung der Robotik und der Positioniereinrichtung in der Handhabungsvorrichtung keine Beeinträchtigungen zu erwarten sind, wenn die Handhabungsvorrichtung insgesamt atmosphärisch gekapselt in einer Transferkammer untergebracht ist.

Insbesondere ist auch der bauliche Aufwand für die Zusammenfassung von Robotik und Positioniereinrichtung dadurch zu verringern, dass die Positioniereinrichtung in einen der Gliederarme der Robotik integriert ist, was auch für die der Positioniereinrichtung zugehörige Sensorik zweckmäßig ist.

Weitere Einzelheiten und Merkmale der Erfindung, auch hinsichtlich ihrer Funktionalitäten, ergeben sich aus den Ansprüchen und der nachfolgenden Beschreibung mit zugehörigen Zeichnungen.

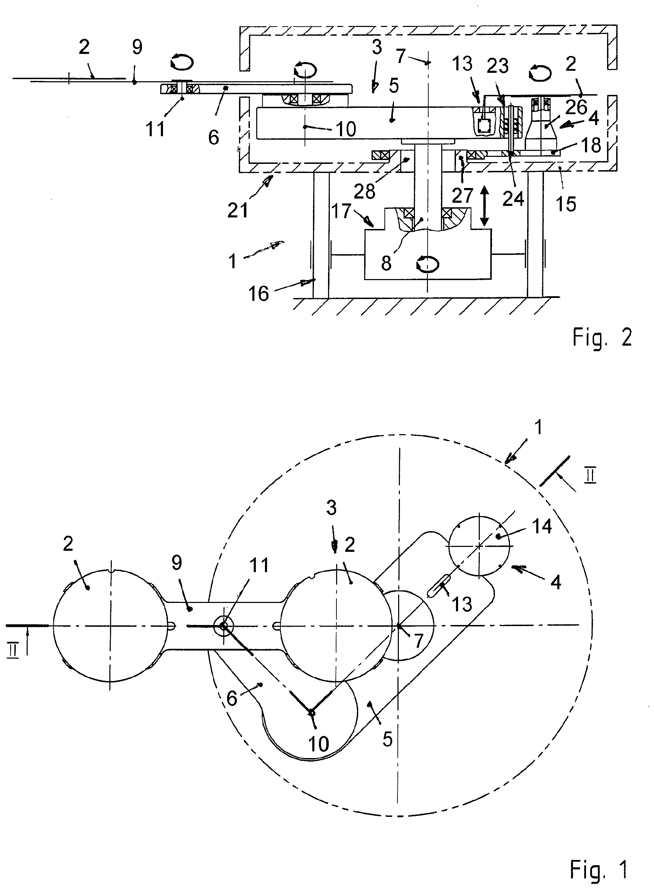

In den Zeichnungen zeigen, stark schematisiert und weitgehend auf die Veranschaulichung des jeweiligen Arbeitsprinzips beschränkt,
- Fig. 1: eine Handhabungsvorrichtung für Substrate mit hierzu angedeuteter Transferkammer für die Substrate, wobei die Transferkammer eine Robotik für die Handhabung der Substrate sowie ergänzend zur Robotik eine Positioniereinrichtung für die Substrate zeigt, Robotik und Positioniereinrichtung somit beide Teil der Handhabungsvorrichtung sind, für die eine zentrale Drehachse vorgesehen ist, wobei die Positioniereinrichtung zur Robotik synchron mitdrehend angeordnet ist,
- Fig. 2: eine schematisierte Schnittdarstellung durch die in Fig. 1 dargestellte Handhabungsvorrichtung bei einer Schnittführung II-II gemäß Fig. 1,
- Fig. 3: eine der Fig. 1 weitgehend entsprechende Draufsicht, in der die Positioniereinrichtung baulich in die Robotik der Handhabungsvorrichtung integriert ist und die Transferkammer mit in Durchgriffsrichtung der Robotik liegenden, bevorzugt verschließbaren Durchgriffsöffnungen (Schleusen) versehen ist,
- Fig. 4: eine zur Fig. 3 ergänzte Schnittdarstellung bei einer Schnittführung gemäß IV-IV, in der die Positioniereinrichtung im Gegensatz zur Darstellung gemäß Fig. 2 kein von der Robotik baulich separiertes Bauteil zeigt, sondern in einen Teil der Robotik baulich integriert ist,
- Fig. 5: bis 8 bezogen auf das Ausführungsbeispiel gemäß Fig. 1 und 2 in gleichen Ausschnitten schematisiert das Zusammenwirken der Robotik und der Positioniereinrichtung in verschiedenen Arbeitsphasen, und
- Fig. 9 bis 12: zu den Fig. 5 bis 8 entsprechende Darstellungen bezogen auf das in Fig. 3 und 4 gezeigte Ausführungsbeispiel.
Die erfindungsgemäße Handhabungsvorrichtung für Substrate ist in den Fig. 1 bis 4, ungeachtet von Abweichungen im Aufbau, jeweils insgesamt mit 1 bezeichnet, die über die Handhabungsvorrichtung 1 umzusetzenden Substrate mit 2. Aufgebaut ist die Handhabungsvorrichtung 1 unter Rückgriff auf eine prinzipiell bekannte Robotik 3 und eine prinzipiell ebenfalls bekannte Positioniereinrichtung 4.

Die Robotik 3 weist als Teile einer Gliederkette einen Oberarm 5 und einen Unterarm 6 auf, von denen - analog zur menschlichen Anatomie mit an den Oberkörper anschließendem Oberarm - der Oberarm 5 von einer koaxial zu einer zentralen Drehachse 7 gebildeten Welle 8 ausgeht und getragen ist. Zur Drehachse 7 exzentrisch ist auf dem Oberarm 5 drehbar der Unterarm 6 gelagert, so dass die Robotik 3 im Grundaufbau der eines sogenannten SCARA-Roboters entspricht, dessen Endeffektor 9 um eine Achse 11 drehbar auf dem zur Drehachse 10 zwischen den Armen 5 und 6 abgelegenen Ende des Unterarmes 6 abgestützt ist. Der Endeffektor 9 weist an seinen bezüglich der Achse 11 einander gegenüberliegenden Enden Auflagen 12 für Substrate 2 auf, die, hinsichtlich ihrer Dreh- und Verschiebelage ausgerichtet auf einem drehbaren Auflageteller 14 als Substratauflage der Positioniereinrichtung 4 aufgenommen, zwischen der Positioniereinrichtung 4 und dem Endeffektor 9 umgesetzt werden.

Die lagerichtige Positionierung wird mittels einer Sensorik 13 überwacht, die im Überdeckungsbereich zum auf dem Auflageteller 14 der Positioniereinrichtung 4 jeweils aufliegenden Substrat 2 lagefest am Oberarm 5 der Robotik 3 angeordnet ist. Diese Anordnung erfolgt bevorzugt derart, dass die Sensorik 13 auf die Unterseite des auf dem Auflageteller 14 aufliegenden Substrates 2 ausgerichtet ist.

Bezüglich des Antriebs der Positioniereinrichtung 4, deren Hubverstellung, der Verstellung der Höhenlagen der Substratauflagen seitens der Robotik 3 und der Positioniereinrichtung 4 zueinander, wie auch bezüglich einer möglicherweise zu realisierenden vakuumtauglichen Anordnung der Handhabungsvorrichtung 1 zeigen die Ausgestaltungen unterschiedliche Ansätze.

Für die Erläuterung der Handhabungsvorrichtung 1 gemäß Fig. 1 und 2 wird von einem teilweise nur schematisch angedeuteten Aufbau derselben ausgegangen, bei dem die Robotik 3 und die Positioniereinrichtung 4 in einer Transferkammer 21 mit einem Tragboden 15 angeordnet sind. Die Transferkammer 21 ist beispielsweise zu einem Traggestell 16 für die Handhabungsvorrichtung 1 festgelegt, ebenso wie ein Antriebskasten 17, der die Lagerung der Welle 8 aufnimmt und bezogen auf Fig. 1 und 2 deren nicht weiter dargestellten, durch Pfeile veranschaulichten Dreh- und Hubantrieb.

Die Welle 8 durchsetzt ihrerseits dreh- und hubverstellbar den zur Drehachse 7 quer liegenden Tragboden 15 der Transferkammer 21 frei liegend in einer Durchtrittsöffnung 28. Auf die Welle 8 ist die Robotik 3 stirnseitig aufgesetzt, derart, dass diese über die Welle 8 zur zentralen Drehachse 7 der Handhabungsvorrichtung 1 konzentrisch getragen ist. Konzentrisch zur Drehachse 7 ist am Tragboden 15 umschließend zur Durchtrittsöffnung 28 ein Tragbund 27 vorgesehen, auf dem ein Tragarm 18 gelagert ist, der als Tragpodest die Positioniereinrichtung 4 trägt. Diese ist über den Tragarm 18 seitlich angrenzend zum Oberarm 5 positioniert. Der Tragarm 18 ist zum Tragboden 15 höhenfest gelagert und trägt die Positioniereinrichtung 4, so dass durch die Hubverstellung der Welle 8 die von der Welle 8 getragene Robotik 3 in ihrer Hublage relativ zum Tragarm 18 und damit auch zur Positioniervorrichtung 4 verstellbar ist. So ist auch die Hublage der Substratauflagen 12 gegenüber dem Auflageteller 14 der Positioniervorrichtung 4 verstellbar, wie dies für die Übergabe von Substraten 2 zwischen den Substratauflagen 12 des Endeffektors 9 und dem Auflageteller 14 der Positioniereinrichtung 4 erforderlich ist.

Bei Drehbewegungen der Welle 8 wird der Tragarm 18 synchron mitdrehend zum Oberarm 5 der Robotik 3 mitbewegt. Hierzu ist eine Mitnehmeranordnung 23 vorgesehen, über die der Tragarm 18 gegen den Oberarm 5 drehfest festgelegt wird. Die Mitnehmeranordnung 23 ist veranschaulicht durch einen zur Drehachse 7 parallel hubverstellbaren Kupplungsstift 24, der im Oberarm 5 in Hubrichtung verschiebbar geführt abgestützt und mit dem Tragarm 18 fest verbunden ist. Im Rahmen der Erfindung können auch andere Mitnehmeranordnungen vorgesehen sein.

In der Zeichnung neben der Mitnehmeranordnung 23 ist im Oberarm 5 oder am Oberarm 5 die Sensorik 13 angeordnet. Diese liegt im Überdeckungsbereich zum jeweils auf dem Auflageteller 14 liegenden Substrat 2, dessen jeweils gewünschte Lage, insbesondere Drehposition, entsprechend der gewünschten Positionierung der Substrate 2 auf der oder den Substratauflagen 12 überwacht wird.

Die angesprochenen Verstellbarkeiten der Robotik 3 ausgehend von der jeweiligen Dreh- und Hubverstellung der Welle 8 sind in den Fig. 1, 2 und 5 bis 8 durch Pfeile veranschaulicht, ebenso die Drehverstellung des Auflagetellers 14 der Positioniereinrichtung 4. Die Positioniereinrichtung 4 mit dem Auflageteller 14 ist zum Tragarm 18 über ein Gehäuse 26 festgelegt, das den entsprechenden motorischen Drehantrieb M für den Auflageteller 14 aufnimmt.

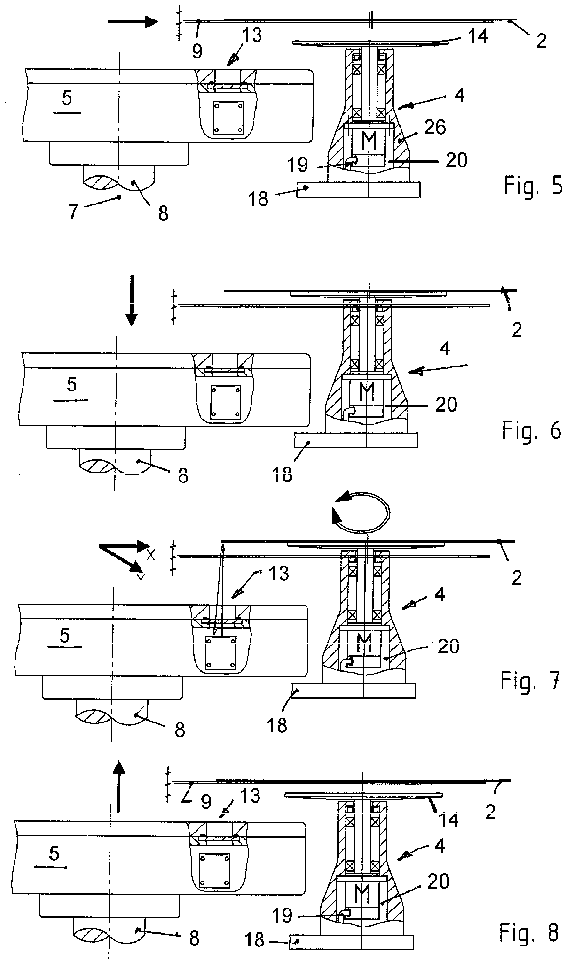

In den Fig. 5 bis 8 ist ausgehend von der Fig. 5 die Positionierung eines Substrates 2 über den Endeffektor 9 in abgehobener Überdeckungslage zum Auflageteller 14 gezeigt (Übergabe auf den Auflageteller 14), in Fig. 6 abgesenkt auf den Auflageteller 14 durch Hubverstellung der die Robotik 3 tragenden Welle 8. Fig. 7 zeigt, dass hierbei über die Sensorik 13 die Ausrichtung des Substrates 2 zum Tragteller 14 beobachtet, kontrolliert und gegebenenfalls auch gesteuert wird. Über die Robotik 3 ist dabei die Positionierung der Substrate 2 hinsichtlich ihrer Lage zur Ebene des Auflagetellers 14 einstellbar, während durch Drehung des Auflagetellers 14 über die Motorik M die Drehlage einzustellen ist. Entsprechend positioniert und ausgerichtet wird das Substrat 2 gemäß Fig. 8 durch Hubverstellung der Robotik 3 wieder vom Auflageteller 14 übernommen und kann nun über die Robotik 3 entsprechend dem weiteren Arbeitsverlauf positioniert, zum Beispiel auf einzelne Arbeitsstationen übergeben werden.

Wie aus den Zeichnungen deutlich wird, ist durch die Tragverbindung der Welle 8 zur Positioniereinrichtung 4 die Hubverstellung der Robotik 3 nicht beeinträchtigt, und auch nicht deren Zugriff auf die Positioniereinrichtung 4 und zu etwaigen über die Handhabungsvorrichtung 1 zu versorgenden und mit dieser verbundenen Arbeits- oder Prozessstationen.

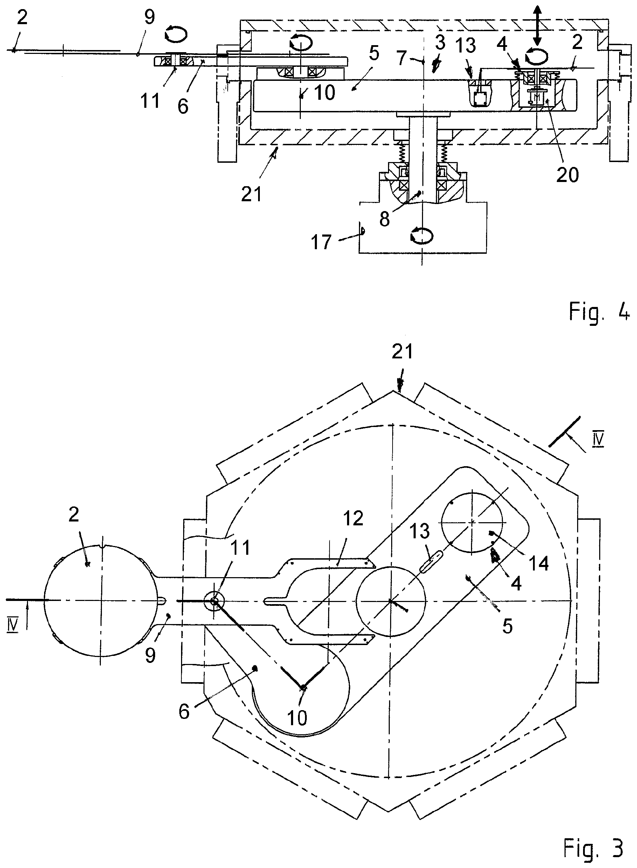

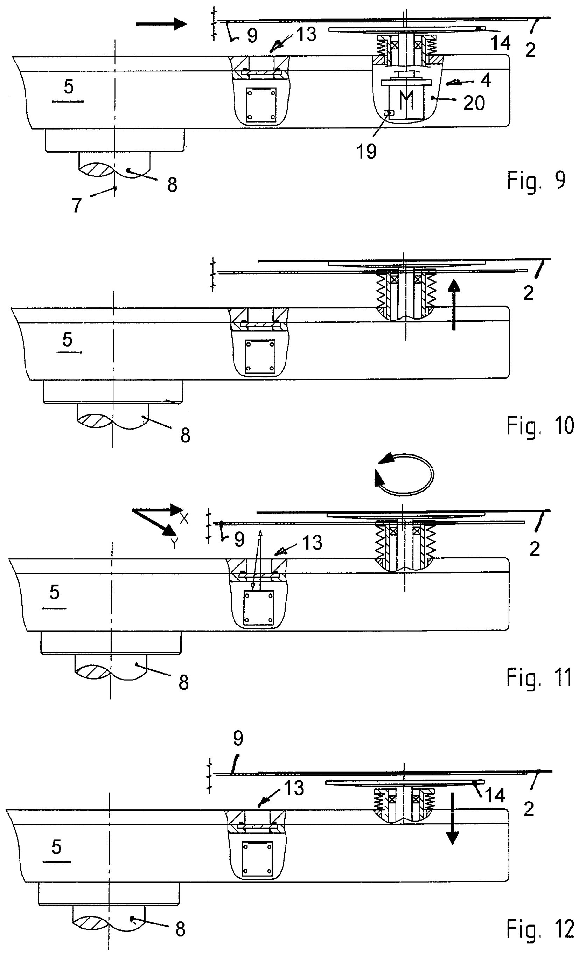

Abweichend von der Ausgestaltung gemäß Fig. 1, 2 und 5 bis 8 veranschaulichen Fig. 3 und 4 sowie 9 bis 12 eine Lösung, bei der die Positioniereinrichtung 4 in einen zumindest teilweise als Hohlkammer ausgebildeten Aufnahmeraum 20 des Oberarmes 5 der Robotik 3 integriert untergebracht ist und somit unmittelbar in Drehrichtung über den Oberarm 5 mitgenommen wird. Dies ermöglicht in zweckmäßiger Weise den Einsatz einer eigenständigen Motorik M als Dreh- und Hubantrieb für den Auflageteller 14 der Positioniereinrichtung 4. Die Fig. 9 bis 12 zeigen, analog zu den Fig. 5 bis 8, den funktionalen Ablauf der Umsetzung von Substraten 2 zwischen dem Endeffektor 9 und der Positioniereinrichtung 4, verdeutlicht durch die jeweilige Verstellung bzw. Bewegung veranschaulichende Pfeile. Hierbei wird deutlich, dass bezogen auf eine Lösung mit Dreh- und Hubverstellung des Auflagetellers 14 bezüglich der Übergabe der Substrate 2 zwar auf eine Hubverstellung der Robotik 3 verzichtet werden könnte, diese Hubverstellung aber für einen schnelleren Durchsatz von Substraten 2 zu insbesondere in Verbindung mit Endeffektoren 9 miteinander gegenüberliegenden Substratauflagen 12 zweckmäßig und nahezu ohne Zusatzaufwand erreichbar ist.

In Fig. 4 ist ferner angedeutet und ersichtlich, dass der Antrieb M für die Positioniereinrichtung 4 in einfacher Weise gekapselt (Aufnahmeraum 20) in den Oberarm 5 integriert werden kann, so dass auch insoweit atmosphärische Sonderbedingungen gewährleistet werden können. So sind auch innerhalb der gehäuseumschlossenen Transferkammer 21 für die Handhabungsvorrichtung 1 mit Robotik 3 und Positioniereinrichtung 4 unterschiedliche atmosphärische Bedingungen in einfacher Weise zu realisieren - angedeutet durch einen Kühlanschluss 19 für den in dem Aufnahmeraum 20 liegenden Antrieb M -, wobei auch die Einführung der zentralen Welle 8 in die Transferkammer 21 trotz der axialen Verschiebbarkeit der Welle 8 in bekannter Weise vakuumtauglich gestaltet werden kann, wie aus Fig. 4 ersichtlich.

Insgesamt gesehen lässt sich durch die erfindungsgemäße Ausgestaltung für eine Handhabungsvorrichtung 1 eine räumlich sehr kompakte Ausgestaltung erreichen, die zudem in vielfältigen Abwandlungen zu gestalten und damit an jeweilige Sonderverhältnisse unter Beibehaltung des Prinzips in vorteilhafter Weise anzupassen ist.

Zu solchen Sonderbedingungen zählt beispielsweise ein möglicher Einsatz der Handhabungsvorrichtung 1 gemäß Fig. 3 und 4 als Verteil- und Durchgangsstation zwischen einer Mehrzahl anzudockender Prozess-, Arbeits-, Speicher- oder sonstiger Stationen, für die zumindest teilweise, gegebenenfalls aber auch jeweils eigenständige Reinraumbedingungen einzuhalten sind. Dies gegebenenfalls auch bei Anordnung der atmosphärisch gekapselten Handhabungsvorrichtung 1 und der mit dieser insbesondere über schaltbare Schleusen verbundenen Stationen in einer oder unterschiedlichen Arbeits- oder Reinraumatmosphären, die bei Beschickung wie auch im Arbeitsprozess nicht vermischt werden dürfen. So könnten beispielsweise unterschiedliche Prozessstationen bei Reinraumgegebenheiten in der Transferkammer 21 bedient werden, ferner auch diese Reinraumgegebenheiten durch entsprechende Spülanschlüsse zur Transferkammer 21 jeweils eingestellt werden und schließlich im Arm 5 vorgesehenen Räume (Aufnahmeraum 20) über die Wellenverbindung an eine weitere Atmosphäre, insbesondere eine Sonderatmosphäre angeschlossen sein. Es könnte also ein Aufbau geschaffen sein, bei dem die Verbindung von der Transferkammer 21 zu zumindest drei atmosphärisch unterschiedlichen, angeschlossenen Arbeitsanschlüssen in einfacher Weise erreicht wird.

Ungeachtet der Vielzahl der Anschlussmöglichkeiten ist im Rahmen der Erfindung trotzdem ein hoher Durchsatz zu erreichen, insbesondere bei Ausbildung der Robotik 3 mit einem zweiarmigen Endeffektor 9, der es ermöglicht, dass das eine Ende des Endeffektors 9 ein Substrat 2 trägt, das ausgerichtet werden soll, während das andere Ende des Endeffektors 9 ein bereits ausgerichtetes Substrat 2 einer anderen Prozessstation zugeführt und aus dieser entnommen wird. Ferner, dass das eine Ende des Endeffektors 9 ein Substrat 2 trägt, das bereits ausgerichtet wurde, während das andere Ende des Endeffektors 9 ein bereits ausgerichtetes Substrat entnimmt oder zuführt. Schließlich, dass ein Ende des Endeffektors 9 ein Substrat 2 trägt, das bereits ausgerichtet wurde, während das andere Ende des Endeffektors 9 ein weiteres Substrat 2 trägt, das ausgerichtet werden soll.

Der Schutzbereich des europäischen Patents und der europäischen Patentanmeldung wird durch die Patentansprüche bestimmt.

## Patentansprüche

1. Handhabungsvorrichtung (1) für Substrate (2) mit zentraler Drehachse (7) für eine auf einen Endeffektor (9) mit zumindest einer Substratauflage (12) auslaufenden Robotik (3) und im Zugriffsbereich des Endeffektors (9) der Robotik (3) liegender Positioniereinrichtung (4) mit zur zentralen Drehachse (7) senkrecht liegendem, drehbaren Auflageteller (14) für die umzusetzenden Substrate (2),
wobei die Positioniereinrichtung (4) einen Bestandteil der Robotik (3) bildet und zur Robotik (3) synchron mitdrehend angetrieben ist,
wobei die Robotik (3) eine Gliederkette bildet und die Positioniereinrichtung (4) drehfest gegen den mit einer zur zentralen Drehachse (7) koaxialen Welle (8) verbundenen Oberarm (5) der Robotik (3) festgelegt ist, und
wobei die Handhabungsvorrichtung (1) gekapselt und mit atmosphärisch gegeneinander abgegrenzten Aufnahmeräumen (20) für zumindest jeweils Teile der Robotik (3) und Teile der Positioniereinrichtung (4) vakuumtauglich ausgebildet ist.

2. Handhabungsvorrichtung nach Anspruch 1,
**dadurch gekennzeichnet,**
**dass** von der Positioniereinrichtung (4) zumindest der Auflageteller (14) höhenfest angeordnet ist.

3. Handhabungsvorrichtung nach Anspruch 1,
**dadurch gekennzeichnet,**
**dass** von der Positioniereinrichtung (4) zumindest der Auflageteller (14) hubverstellbar ist.

4. Handhabungsvorrichtung nach einem der vorhergehenden Ansprüche,
**dadurch gekennzeichnet,**
**dass** die Robotik (3) und/oder die Positioniereinrichtung (4) zumindest bezüglich ihrer Auflagen (12, 14) für die Substrate (2) gegeneinander höhenverstellbar sind.

5. Handhabungsvorrichtung nach einem der Ansprüche 1 bis 4,
**dadurch gekennzeichnet,**
**dass** ein atmosphärisch abgegrenzter Aufnahmeraum (20) für zumindest den Dreh- und/oder Hubantrieb M der Positioniereinrichtung (4) in dem um die zentrale Drehachse (7) drehbaren Oberarm (5) der Gliederkette der Robotik (3) oder in einem Gehäuse (26) aufgenommen ist, das von einem synchron mitdrehend zum Oberarm (5) der Robotik (3) mitbewegten Tragarm (18) getragen ist.

6. Handhabungsvorrichtung nach Anspruch 5,
**dadurch gekennzeichnet,**
**dass** der Aufnahmeraum (20) als Hohlkammer ausgebildet und an die Atmosphäre angeschlossen ist.

## Claims

1. Handling apparatus (1) for substrates (2), having a central axis of rotation (7) for robotics (3) that end at an end effector (9) with at least one substrate pad (12), and a positioning device (4) located in the access region of the end effector (9) of the robotics (3) and having a rotatable support plate (14), which is perpendicular to the central axis of rotation (7), for the substrates (2) to be transferred,
wherein the positioning device (4) forms part of the robotics (3) and is driven so as to rotate synchronously with the robotics (3),
wherein the robotics (3) form a linked chain, and the positioning device (4) is secured for conjoint rotation against the upper arm (5) of the robotics (3), the upper arm being connected to a shaft (8) that is coaxial with respect to the central axis of rotation (7), and wherein the handling apparatus (1) is encapsulated and is designed to be suitable for a vacuum with receiving compartments (20), which are delimited from one another atmospherically, for at least in each case parts of the robotics (3) and parts of the positioning device (4).

2. Handling apparatus according to Claim 1,
**characterized**
**in that** of the positioning device (4) at least the support plate (14) is arranged at a fixed height.

3. Handling apparatus according to Claim 1,
**characterized**
**in that** of the positioning device (4) at least the support plate (14) is adjustable in terms of lift.

4. Handling apparatus according to one of the preceding claims,
**characterized**
**in that** the robotics (3) and/or the positioning device (4) are/is height-adjustable in relation to one another at least with respect to their pads (12, 14) for the substrates (2).

5. Handling apparatus according to one of Claims 1 to 4,
**characterized**
**in that** an atmospherically delimited receiving compartment (20) for at least the rotary and/or lifting drive M of the positioning device (4) is accommodated in the upper arm (5), which is rotatable about the central axis of rotation (7), of the linked chain of the robotics (3) or in a housing (26) which is carried by a carrying arm (18) moving in a manner rotating synchronously with the upper arm (5) of the robotics (3).

6. Handling apparatus according to Claim 5,
**characterized**
**in that** the receiving compartment (20) is designed as a hollow chamber and is connected to the atmosphere.

## Revendications

1. Arrangement de manipulation (1) pour des substrats (2), comprenant un axe de rotation (7) central pour un système robotique (3) qui se termine sur un effecteur terminal (9) comprenant au moins un support de substrat (12) et un dispositif de positionnement (4), se trouvant dans la zone d'accès de l'effecteur terminal (9) du système robotique (3), avec un plateau d'appui (14) pour les substrats (2) à déplacer qui est perpendiculaire à l'axe de rotation (7) central,
le dispositif de positionnement (4) formant un élément constitutif du système robotique (3) et étant entraîné en rotation commune synchrone par rapport au système robotique (3),
le système robotique (3) formant une chaîne de membres et le dispositif de positionnement (4) étant fixé en rotation solidaire contre le bras supérieur (5) du système robotique (3), relié à un arbre (8) coaxial par rapport à l'axe de rotation (7) central, et
l'arrangement de manipulation (1) étant encapsulé et configuré de manière compatible avec le vide avec des espaces d'accueil (20) délimités les uns des autres sur le plan atmosphérique pour respectivement au moins des parties du système robotique (3) et des parties du dispositif de positionnement (4).

2. Arrangement de manipulation selon la revendication 1, **caractérisé en ce que** du dispositif de positionnement (4), au moins le plateau d'appui (14) est disposé à une hauteur fixe.

3. Arrangement de manipulation selon la revendication 1, **caractérisé en ce que** du dispositif de positionnement (4), au moins le plateau d'appui (14) peut être positionné par excursion.

4. Arrangement de manipulation selon l'une des revendications précédentes, **caractérisé en ce que** le système robotique (3) et/ou le dispositif de positionnement (4) sont positionnables en hauteur l'un par rapport à l'autre au moins en référence à leurs appuis (12, 14) pour les substrats (2).

5. Arrangement de manipulation selon l'une des revendications 1 à 4, **caractérisé en ce qu'**un espace d'accueil (20) délimité sur le plan atmosphérique, pour au moins un entraînement en rotation et/ou en excursion M du dispositif de positionnement (4), est accueilli dans le bras supérieur (5), rotatif autour l'axe de rotation (7) central, de la chaîne de membres du système robotique (3) ou dans un boîtier (26) qui est porté par un bras porteur (18) déplacé conjointement en rotation commune synchrone par rapport au bas supérieur (5) du système robotique (3).

6. Arrangement de manipulation selon la revendication 5, **caractérisé en ce que** l'espace d'accueil (20) est réalisé sous la forme d'une chambre creuse et il est raccordé à l'atmosphère.
